# FASCICULE DE BREVET EUROPEEN

(11) **EP 2 537 254 B1**
(45) Date de publication et mention de la délivrance du brevet: **25.01.2017**
(21) Numéro de dépôt: 11708513.4
(22) Date de dépôt: 27.01.2011
(51) Int. Cl.: H03K 17/96

(54) **CONTACTEUR ÉLECTRIQUE À COMMANDE SENSITIVE.**
ELEKTRISCHER SCHALTER MIT EMPFINDLICHER STEUERUNG
ELECTRIC CONTACTOR HAVING SENSITIVE CONTROL

(30) Priorité: 18.02.2010 FR 1000673
(43) Date de publication de la demande: 26.12.2012
(73) Titulaire: Les Robinets Presto, 92120 Montrouge (FR)
(72) Inventeur: DUTHEIL, Daniel, F-17132 Meshers (FR)
(74) Mandataire: Eidelsberg, Olivier Nathan
(86) Numéro de dépôt international: PCT/FR2011/000038
(87) Numéro de publication internationale: WO 2011/101552

(56) Documents cités:
- EP-A2- 0 335 838
- WO-A1-98/36494
- DE-U1- 20 301 325
- US-A- 6 064 141
- US-A1- 2007 057 604
- US-B1- 6 310 428

## Description

La présente invention est relative à un contacteur électrique à commande sensitive, plus particulièrement mais non exclusivement, destiné à la commande de l'électrovanne d'un robinet.

Le problème posé consiste à réaliser un contacteur dont la fabrication puisse être rationalisée et qui, en exploitation, soit bien protégé contre les actes de vandalisme.

Le principe de fonctionnement d'un tel contacteur, consiste à appliquer une légère pression sur une surface qui est transmise à une pastille piézoélectrique qui délivre un signal, ce dernier étant, ensuite, traité à travers un circuit électronique afin d'obtenir un signal de commande prédéterminé.

Les composants nécessaires à la réalisation du circuit électronique sont fixés sur la face d'une carte, réalisée en un matériau isolant, contre l'autre face de laquelle est appliquée la pastille piézoélectrique.

Si l'incorporation de la pastille à la carte électronique ne pose pas de problème, il n'en est pas de même en ce qui concerne la réalisation de la liaison entre la face de la carte comportant la pastille et la cloison de protection.

En l'état de la technique, cette liaison est réalisée au moyen d'un adhésif double face. La carte est appliquée en pression contre la cloison de protection et la pression est maintenue un certain temps pour que le collage soit efficace. Cette façon de procéder, outre qu'elle soit délicate en raison de la présence des composants électroniques, nécessite un certain temps et cet arrêt dans le processus de fabrication du contacteur n'est pas tolérable dans l'optique d'une fabrication industrielle.

Le problème posé est résolu par un contacteur selon la revendication 1.

Le contacteur de l'invention est remarquable en ce qu'il comporte un boîtier métallique, dont le fond, aminci, constitue la cloison derrière laquelle est disposée la carte électronique qui est maintenue appliquée contre cette dernière par un organe tubulaire dont une extrémité, élastiquement déformable, est appliquée contre la périphérie de ladite carte, ledit boîtier et ladite carte comportant des moyens qui en coopération assurent le maintien dudit organe.

Les documents WO98/36494 et US2007/0057604 décrivent un exemple de contacteurs piézoélectrique.

La présente invention sera mieux comprise par la description qui va suivre faite en se référant aux dessins annexés à titre d'exemple indicatif, seulement, sur lesquels :

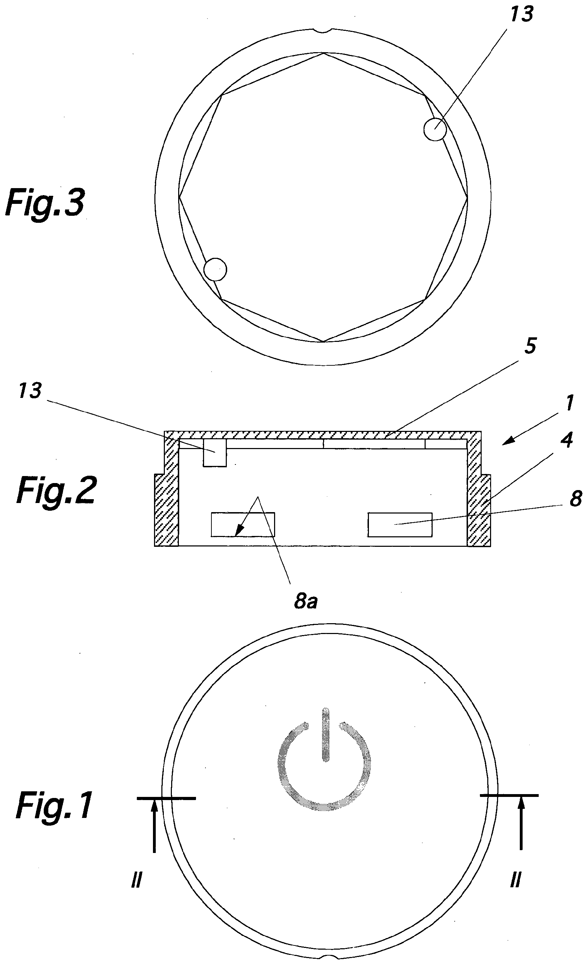

- la figure 1 est la vue de dessus du boîtier ;
- la figure 2 est une vue en coupe effectuée selon la ligne II-II de la figure 1 ;
- la figure 3 est la vue de dessous du boîtier ;
- la figure 4 est la vue de dessus de l'organe tubulaire de verrouillage ;
- la figure 5 est une vue en coupe effectuée selon la ligne V-V de la figure 4 ;
- la figure 6 est la vue de dessous de la figure 4 ;
- la figure 7 est une vue en perspective éclatée montrant les trois éléments constituant le contacteur ;
- la figure 8 est une vue en coupe du contacteur (la coupe étant effectuée selon la ligne brisée VIII-VIII de la figure 4) ;
- la figure 9 illustre un mode de mise en oeuvre du contacteur ;
- la figure 10 est une vue analogue à celle 2, montrant une variante de réalisation.

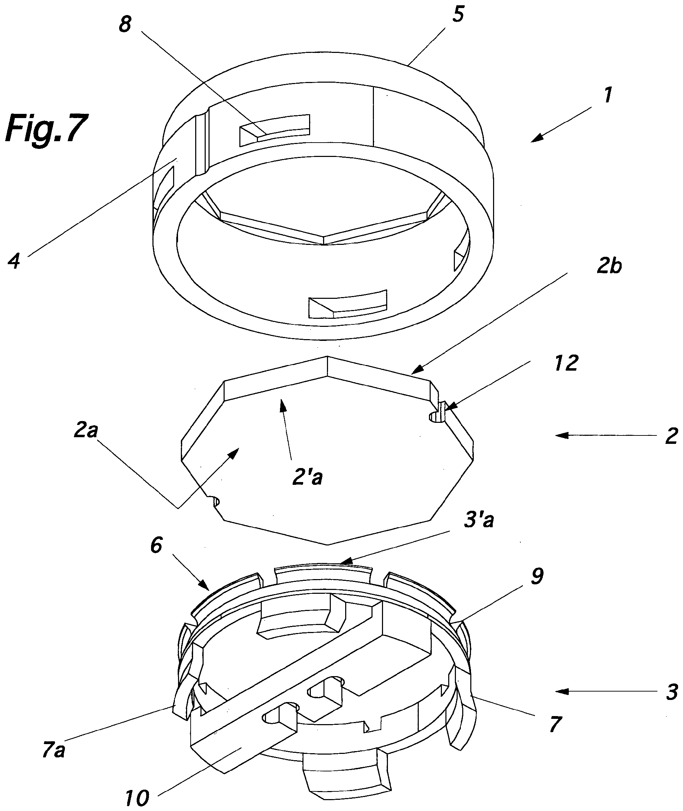

En se reportant aux dessins et selon un mode de réalisation, (et notamment à la figure7), on voit que le contacteur comporte trois parties 1, 2 et 3.

La partie 1 est formée par un boîtier métallique comportant une enveloppe latérale 4 et un fond 5 suffisamment mince pour se déformer sous l'action d'une légère pression manuelle.

Selon un mode de réalisation, le boîtier affecte une forme circulaire.

La partie 2 est constituée par une plaque, dénommée ci-après « carte » réalisée en un matériau isolant, comportant des composants électroniques (non représentés) sur sa face 2a et une pastille piézoélectrique (non représentée) sur sa face 2b qui est normalement appliquée contre la face interne du fond 5, selon on processus connu.

Il est à noter que, les câbles électriques d'alimentation du circuit électronique et de départ du signal de commande n'ont pas été représentés, mais sont judicieusement reliés au circuit électronique de la face 2a.

La partie 3, qui constitue l'organe de maintien tubulaire de la carte 2, affecte la forme d'une bague circulaire et est réalisée en une matière plastique élastiquement déformable.

L'extrémité 6 de la bague 3, normalement en contact avec la carte 2, est conformée pour permettre un léger écrasement sous l'action d'une poussée axiale et exercer une précontrainte de compression sur ladite carte.

Le diamètre externe de la bague 3 est inférieur à celui interne de la partie 2 du boîtier. Toutefois la bague 3 présente, au moins, une patte 7 qui s'étend au-delà du diamètre de ladite bague. La patte 7 s'étendant sensiblement obliquement par rapport à l'axe de la bague de la façon à ce que la distance qui sépare un point de la périphérie de ladite patte et ledit axe augmente de l'extrémité de la bague en contact avec la carte à l'autre extrémité.

De cette façon, lorsque la bague 3 est engagée dans le boîtier 1, la patte 7 fléchit élastiquement jusqu'au moment où elle peut se détendre dans une encoche 8 prévue dans la partie 4 dudit boîtier. Dans cette position, l'extrémité 7a de la patte prend appui contre le bord 8a de l'encoche et s'oppose au déplacement axial de la bague et, par suite, à celui de la carte 2 qui est appliquée et maintenue sans jeu contre la face interne du fond 5.

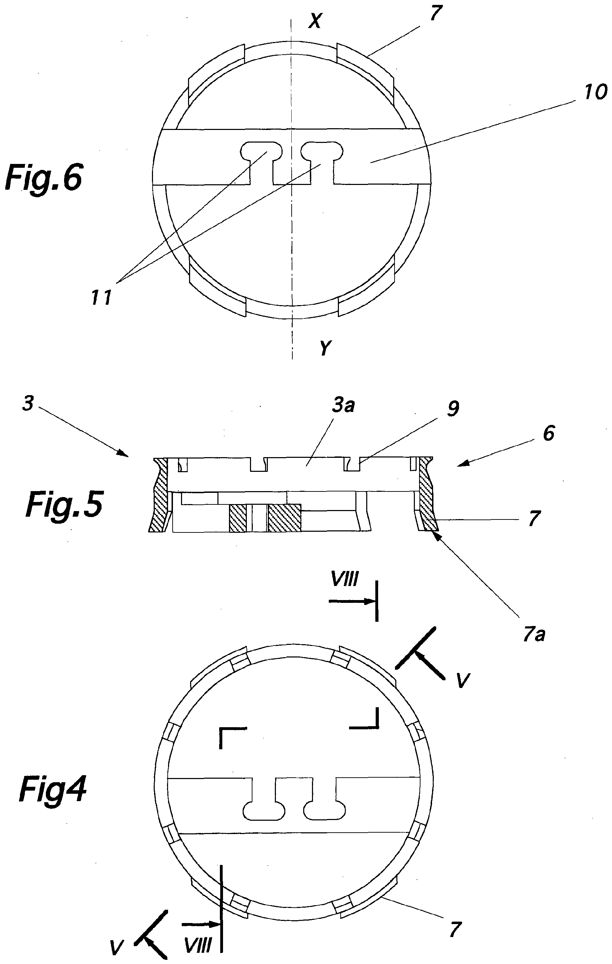

Comme cela ressort des dessins, la bague 3 présente deux paires de pattes disposées symétriquement par rapport à un plan diamétral (trace en XY sur la figure 6) et le boîtier 1 comporte, donc quatre encoches correspondantes.

Selon une caractéristique de l'invention, la carte 2 affecte la forme d'un octogone régulier. Elle permet d'industrialiser la fabrication des circuits et notamment de faciliter le découpage des cartes 2 qui sont réalisées à l'origine sur une plaque unique comportant une pluralité de circuits identiques.

Pour assurer un bon contact entre l'extrémité de la bague 3 et la périphérie de la plaque octogonale, des encoches 9 sont pratiquées sur l'extrémité 6 de ladite bague délimitant des portions 3a prenant chacune appui contre la partie correspondante de la plaque 2 (par exemple 3'a contre 2'a -voir figure 7).

La bague 3 est complétée par une barre 10 comportant deux encoches 11, à section en forme de Té utilisées pour guider les câbles électriques. La barre 10 s'étend selon une direction perpendiculaire à l'axe XY. Cette disposition constitue un repère visuel avantageux lors du clipsage de la bague 3 à l'instar d'un dispositif détrompeur.

En ce qui concerne le détrompage, il faut signaler que la carte 2 présente à sa périphérie, au moins, une encoche 1 2 susceptible de coopérer avec un doigt 13 du boîtier pour positionner la dite carte et, par suite, les câbles électriques.

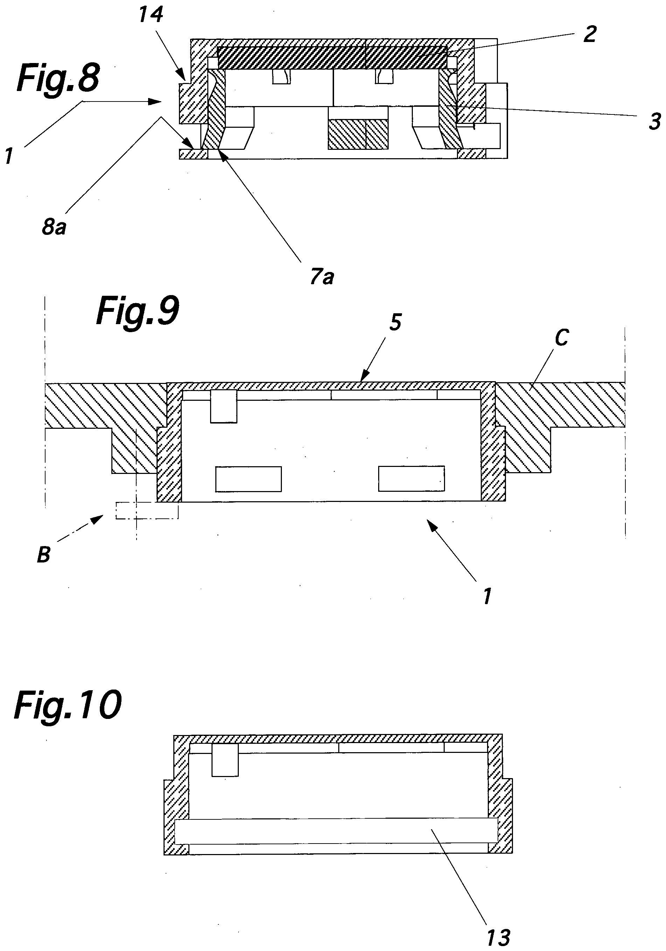

Selon un mode de réalisation, le boîtier 1 présente, à sa périphérie, un épaulement 14, pouvant coopérer à la fixation du contacteur dans un corps C tel que montré sur la figure 9, des brides telles que suggérées en B sur ladite figure assurent le maintien, chaque bride peut être constituée par une simple vis dont la tête prend appui sous le bord inférieur dudit boîtier.

Le boîtier qui vient d'être décrit est obtenu par injection et c'est la raison de la forme et de la disposition des encoches 8. Si ce boîtier est obtenu par usinage, il est avantageux de remplacer les encoches 8 par une rainure 13, comme montré sur la figure 10.

L'élasticité, de la bague 3 et celle de la couche de matière adhésive interposée entre le fond du boîtier et la face correspondante, est suffisante pour maintenir un contact sans jeu. La géométrie, les dimensions et la matière de la bague 3 sont définies de telle sorte que la valeur de la précontrainte exercée par celle-ci sur la carte 2 reste dans les valeurs définies en s'affranchissant des tolérances dimensionnelles inhérentes à la fabrication des différentes pièces.

Toutefois, dans le temps, les matériaux peuvent perdre de leurs qualités, c'est pourquoi l'invention prévoit, lorsque les trois parties sont assemblées comme montré sur la figure 8, de recouvrir la face 2a de la carte d'une résine polyuréthane bi-composants permettant une prise à froid, par exemple" qui en durcissant isole le circuit électronique de l'humidité et maintient la dite carte indépendamment de l'action de la bague clips 3.

## Revendications

1. Contacteur électrique à commande sensitive utilisant une pastille piézoélectrique incorporée à une première face (2b) d'une carte (2) réalisée en un matériau isolant. Ledit contacteur comporte un boîtier (1), métallique dont le fond (5), suffisamment mince pour se déformer sous l'action d'une légère pression manuelle, constitue une cloison de protection contre laquelle est appliquée la première face (2b) par l'entremise d'un organe tubulaire ou d'une bague (3), dont une extrémité en contacte avec la carte et élastiquement déformable, est appliquée contre la périphérie de ladite carte, ledit boîtier et ladite carte comportant des moyens qui en coopération assurent le maintien dudit organe (3), ou de ladite bague, **caractérisé en ce que** la bague (3) présente au moins une patte (7) qui s'étend au-delà du diamètre de ladite bague, sensiblement obliquement par rapport à l'axe de la bague de façon à ce que la distance qui sépare un point de la périphérie de ladite patte et ledit axe augmente de l'extrémité de la bague en contact avec la carte à l'autre extrémité et **en ce que** le boîtier présente, au moins, une encoche (8), ou une rainure périphérique (13), contre le bord (8a) de laquelle l'extrémité (7a) de la patte (7) prend appui lorsque la carte est convenablement appliquée sous le fond dudit boîtier.

2. Contacteur selon la revendication 1, **caractérisé en ce que** la bague (3) est réalisée en une matière élastiquement déformable et **en ce que** l'extrémité (6) en contact avec la carte est conformée pour permettre un léger écrasement sous l'effet d'une poussée axiale en maintenant une précontrainte.

3. Contacteur selon l'une des revendications 1 ou 2, **caractérisé en ce que** l'extrémité (6) de la bague (3) en contact avec la carte présente des encoches (9) délimitant des portions (3a) indépendantes.

4. Contacteur selon l'une des revendications 1 à 3, **caractérisé en ce que** la carte affecte la forme d'un octogone régulier.

5. Contacteur selon l'une des revendications 1 à 4, **caractérisé en ce que** le boîtier (1) présente, à sa périphérie, un épaulement (14).

6. Contacteur selon l'une des revendications 1 à 5, **caractérisé en ce que**, lorsque la bague est verrouillée dans le boîtier on dépose sur celle-ci une couche de résine polyuréthane qui en durcissant isole le circuit électronique de l'humidité et maintient la carte indépendamment de l'action de la bague (3).

7. Contacteur selon l'une des revendications 1 à 6, **caractérisé en ce que** la bague présente, au moins, deux pattes (7) diamétralement opposées.

## Patentansprüche

1. Ein elektrischer Schalter mit Berührungssteuerung (Touch-Control), der eine piezoelektrische Platte, die an einer ersten Fläche (2b) einer Karte (2), welche aus einem isolierenden Material hergestellt ist, eingebunden ist, verwendet, wobei besagter Schalter ein Metallgehäuse (1) umfasst, von dem der Boden (5), welcher ausreichen dünn ist, um unter der Einwirkung eines leichten manuellen Drucks verformt zu werden, eine Schutzwand bildet, gegen welche die erste Fläche (2b) durch die Zwischenstellung eines rohrförmigen Elements oder Rings (3) angebracht ist, von dem ein Ende, welches Kontakt mit der Karte hat und elastisch verformbar ist, gegen den Umfang von besagter Karte angebracht ist, wobei besagtes Gehäuse und besagte Karte Mittel umfassen, welche zusammen bewirken, dass das besagte Element (3) oder besagter Ring in Position gehalten werden,
**dadurch gekennzeichnet, dass** der Ring (3) mindestens eine Haltevorrichtung (7) aufweist, die sich, in Bezug auf die Achse des Rings, über den Durchmesser des besagten Rings hinaus auf eine solche Weise im Wesentlichen schräg erstreckt, dass sich die Distanz von einem Punkt auf dem Umfang von besagter Haltevorrichtung und der besagten Achse von dem Ende des Rings, welches in Kontakt mit der Karte ist, zu dem anderen Ende hin erhöht, und
**dadurch gekennzeichnet, dass** das Gehäuse mindestens eine Aussparung (8) oder eine Umfangsvertiefung (13) aufweist, auf deren Rand (8a) das Ende (7a) der Haltevorrichtung (7) ruht, wenn die Karte passend unter dem Boden des besagten Gehäuses angebracht ist.

2. Der Schalter gemäß Anspruch 1, **dadurch gekennzeichnet, dass** der Ring (3) aus einem elastisch verformbaren Material besteht, und dass das Ende (6), das in Kontakt mit der Karte ist, so ausgebildet ist, dass es eine leichte Abflachung unter Einwirkung eines Axialschubs gestattet, während die Vorspannung beibehalten wird.

3. Der Schalter gemäß einem der Ansprüche 1 oder 2, **dadurch gekennzeichnet, dass** das Ende (6) des Rings (3), das in Kontakt mit der Karte ist, Aussparungen (9) aufweist, die unabhängige Abschnitte (3a) begrenzen.

4. Der Schalter gemäß einem der Ansprüche 1 bis 3, **dadurch gekennzeichnet, dass** die Karte die Form eines regelmäßigen Achtecks annimmt.

5. Der Schalter gemäß einem der Ansprüche 1 bis 4, **dadurch gekennzeichnet, dass** das Gehäuse (1), an seinem Umfang, einen Vorsprung (14) aufweist.

6. Der Schalter gemäß einem der Ansprüche 1 bis 5, **dadurch gekennzeichnet, dass**, wenn der Ring in dem Gehäuse verriegelt ist, auf diesem eine Schicht Polyurethan-Harz aufgetragen ist, das, wenn es aushärtet, den Stromkreis gegen Feuchtigkeit isoliert und die Karte, ungeachtet der Bewegung des Rings (3), in Position hält.

7. Der Schalter gemäß einem der Ansprüche 1 bis 6, **dadurch gekennzeichnet, dass** der Ring mindestens zwei diametral entgegengesetzte Haltevorrichtungen (7) aufweist.

## Claims

1. Electrical contactor with touch control using a piezoelectric pellet incorporated in one face (2b) of a card (2) which is made of an insulating material and the other face (2a) of which comprises an electronic circuit, **characterised in that** it comprises a metal casing (1), of which the bottom (5), which is sufficiently thin to be deformed under the effect of a light manual pressure, constitutes a protective partition against which the first face (2b) is applied by the interposition of a tubular member (3), of which one end, which is elastically deformable, is applied against the periphery of the said card, the said casing and the said card comprising means which, together, bring about the holding of the said member (3), or ring, in position, and **in that** the ring (3) has at least one lug (7) which extends beyond the diameter of the said ring, substantially obliquely in relation to the axis of the ring in such a way that the distance that separates a point on the periphery of the said lug and the said axis increases from that end of the ring which is in contact with the card to the other end, and **in that** the casing has at least one slot (8), or a peripheral groove (13), against the edge (8a) of which the end (7a) of the lug (7) rests when the card is suitably applied under the bottom of the said casing.

2. Contactor according to claim 1, **characterised in that** the ring (3) is made of an elastically deformable material, and **in that** the end (6) which is in contact with the card is shaped so as to allow slight flattening under the effect of an axial thrust, while maintaining a pre-stress.

3. Contactor according to one of claims 1 or 2, **characterised in that** the end (6) of the ring (3) which is in contact with the card has notches (9) which delimit independent portions (3a).

4. Contactor according to one of claims 1 to 3, **characterised in that** the card assumes the shape of a regular octagon.

5. Contactor according to one of claims 1 to 4, **characterised in that** the casing (1) has a shoulder (14) at its periphery.

6. Contactor according to one of claims 1 to 5, **characterised in that**, when the ring is locked in the casing, there is deposited on said ring a layer of polyurethane resin which, on hardening, insulates the electronic circuit from moisture and holds the card in position independently of the action of the ring (3).

7. Contactor according to one of claims 1 to 6, **characterised in that** the ring has at least two diametrically opposed lugs (7).
